# EUROPÄISCHE PATENTSCHRIFT

(11) **EP 2 997 649 B1**
(45) Veröffentlichungstag und Bekanntmachung des Hinweises auf die Patenterteilung: **24.06.2020**
(21) Anmeldenummer: 14710837.7
(22) Anmeldetag: 11.03.2014
(51) Int. Cl.: H02M 1/08, H02M 1/38, H03K 17/06, H02P 7/00, H02M 1/00

(54) **STEUERUNG EINER HALBBRÜCKE**
CONTROL OF A HALF BRIDGE
COMMANDE D'UN DEMI-PONT

(30) Priorität: 14.05.2013 DE 102013208813
(43) Veröffentlichungstag der Anmeldung: 23.03.2016
(73) Patentinhaber: Robert Bosch GmbH, 70442 Stuttgart (DE)
(72) Erfinder: HAUG, Martin, Shanghai 200031 (CN); SCHIEMANN, Werner, 70734 Fellbach (DE); JOOS, Joachim, 70499 Stuttgart (DE)
(86) Internationale Anmeldenummer: PCT/EP2014/054668
(87) Internationale Veröffentlichungsnummer: WO 2014/183900

(56) Entgegenhaltungen:
- EP-A2- 1 691 478
- DE-A1- 10 032 321
- US-A1- 2005 110 475

## Beschreibung

Die Erfindung betrifft die Steuerung einer Halbbrücke. Insbesondere betrifft die Erfindung eine Steuervorrichtung zur Steuerung eines Verbrauchers mittels einer Halbbrücke.

### Stand der Technik

Ein elektrischer Verbraucher kann mittels einer Halbbrücke angesteuert werden, die eine erste Schalteinrichtung zur Verbindung des Verbrauchers mit einem positiven Potential und eine zweite Schalteinrichtung zur Verbindung des Verbrauchers mit einem negativen Potential umfasst. Dabei liegt ein zweiter Anschluss des Verbrauchers üblicherweise an einem vorbestimmten Potential, insbesondere Masse, oder kann mittels einer weiteren Halbbrücke beispielsweise in korrespondierender Weise, jedoch mit umgekehrter Polarität angesteuert werden, siehe z.B. US2005/0110475. Einige Verbraucher, beispielsweise bürstenlose Gleichstrommotoren oder Mehrphasen-Drehstrommotoren, können weitere Halbbrücken erfordern.

Eine Steuereinrichtung ist dazu eingerichtet, stets nur einen der beiden Schalteinrichtungen anzusteuern, um den Verbraucher mit dem jeweils gewünschten Potential zu verbinden. Beispielsweise aufgrund von Fertigungstoleranzen oder Temperatureinflüssen auf die Schalteinrichtungen können Latenzzeiten zwischen dem Ansteuern einer der Schalteinrichtungen und dem Ermöglichen eines Stromflusses durch die Schalteinrichtung variieren. Das über die Zeit gemittelte Potential, das dem Verbraucher durch die Halbbrücke bereitgestellt wird, kann dadurch von einem vorbestimmten Potential abweichen. Anders ausgedrückt kann ein Strom durch den Verbraucher einen vorbestimmten Offset aufweisen. Insbesondere dann, wenn der Verbraucher eine induktive oder kapazitive Last umfasst, kann diese Verschiebung zu erhöhten Verlusten und erhöhten Beanspruchungen der Schalteinrichtungen oder des elektrischen Verbrauchers führen.

Es ist daher Aufgabe der vorliegenden Erfindung, eine Steuerung für einen elektrischen Verbraucher bereitzustellen, die eine verbesserte Steuerung einer Halbbrücke zulässt. Die Erfindung löst diese Aufgabe mittels einer Steuerung mit den Merkmalen des unabhängigen Anspruchs 1. Unteransprüche geben bevorzugte Ausführungsformen wieder.

### Offenbarung der Erfindung

Eine erfindungsgemäße Steuerung für einen elektrischen Verbraucher umfasst eine erste Schalteinrichtung zur Verbindung eines Ausgangs für den Verbraucher mit einem ersten Potential, eine zweite Schalteinrichtung zur Verbindung des Ausgangs mit einem zweiten Potential, eine Steuereinrichtung zur Ansteuerung der Schalteinrichtungen, eine erste Abtasteinrichtung zur Bereitstellung eines ersten Signals in Abhängigkeit eines Schaltzustands der ersten Schalteinrichtung, eine zweite Abtasteinrichtung zur Bereitstellung eines zweiten Signals in Abhängigkeit eines Schaltzustands der zweiten Schalteinrichtung und eine Vergleichseinrichtung zur Bestimmung eines Unterschieds der Schaltzeiten der Schalteinrichtungen auf der Basis der bestimmten Signale.

Auf diese Weise kann eine Differenz zwischen den tatsächlichen Einschaltzeiten der Schalteinrichtungen einer Halbbrücke einfach und genau bestimmt werden. Dadurch kann eine Verschiebung eines Stroms in dem angeschlossenen Verbraucher frühzeitig und genau bestimmt werden. Zur Vermeidung von Schäden können entsprechende Gegenmaßnahmen erleichtert eingeleitet werden.

Die Schalteinrichtungen können grundsätzlich jede Art von steuerbarem Schalter umfassen, beispielsweise einen Halbleiterschalter, etwa einen Bipolartransistor, insbesondere mit isolierter Gate-Elektrode (IGBT). Bevorzugterweise umfasst eine der Schalteinrichtungen einen Feldeffekttransistor, wobei die zugeordnete Abtasteinrichtung dazu eingerichtet ist, einen geschlossenen Schaltzustand zu bestimmen, wenn eine Spannung zwischen einem Gate- und einem Source-Anschluss des Feldeffekttransistors unter einem vorbestimmten Schwellenwert liegt.

Diese Bestimmung kann einfach und genau beispielsweise mittels eines Komparators durchgeführt werden. Diese Herangehensweise kann einfacher und kostengünstiger als beispielsweise das Bestimmen eines durch die Schalteinrichtung fließenden Stroms mittels einer Strommessung durchgeführt werden. Der Komparator kann halbleitertechnisch mit der Halbbrücke oder der Steuereinrichtung oder beiden integriert sein, wodurch Herstellungskosten gesenkt werden können.

Die Vergleichseinrichtung kann in einer ersten Variante analog aufgebaut sein. Dazu kann die Vergleichseinrichtung einen integrierenden Komparator umfassen, der dazu eingerichtet ist, auf der Basis der bestimmten Signale eine Spannung bereitzustellen, deren Abweichung von einem vorbestimmten Potential ein Maß für den Unterschied der Einschaltzeiten darstellt. Die Signale werden dazu mit unterschiedlichen Vorzeichen über die Zeit integriert. Haben die Signale gleiche Länge, sind also die Einschaltzeiten der Schalteinrichtungen gleich, so beträgt die bereitgestellte Spannung vor dem ersten Signal den gleichen Wert wie nach dem zweiten Signal. Anders ausgedrückt verändert sich dann die Spannung am Ausgang des integrierenden Komparators im Mittel über die Zeit nicht.

In einer zweiten Variante ist die Vergleichseinrichtung digital aufgebaut. Die Vergleichseinrichtung kann einen digitalen Zähler umfassen, der dazu eingerichtet ist, ein gleichbleibendes Taktsignal während des ersten Signals aufwärts und während des zweiten Signals abwärts zu zählen, oder umgekehrt, wobei die Abweichung des Zählerstands von einem vorbestimmten Stand ein Maß für den Unterschied der Einschaltzeiten darstellt. Auch hier ändert sich der Zählerstand über die Zeit nicht, wenn die Einschaltzeiten der Schalteinrichtungen gleich sind. Da an einer Halbbrücke anderweitig sicher gestellt wird, dass nicht beide Schalteinrichtungen gleichzeitig angesteuert werden, kann ein Konflikt von gleichzeitig anliegenden ersten und zweiten Signalen ausgeschlossen sein.

In einer Ausführungsform werden die Schalteinrichtungen periodisch angesteuert, wobei jede Periode eine Ansteuerung der ersten und der zweiten Schalteinrichtung umfasst. Das Vergleichen der Signale mittels einer der beiden beschriebenen Varianten kann über mehrere Perioden erfolgen. Dadurch können auch kleinste Unterschiede zwischen den Einschaltzeiten genau erfasst werden. Sporadische Unterschiede der Einschaltzeiten in die eine oder andere Richtung können durch die Betrachtung mehrerer Perioden weg gemittelt werden.

Bevorzugterweise sind die Schalteinrichtungen von einer Halbbrücke oder von einem Brückenzweig einer H-Brücke umfasst. Solche Schaltungen werden beispielsweise in integrierten Steuerungen zum Betreiben von Elektromotoren, insbesondere bürstenlosen Elektromotoren, verwendet. In einer besonders bevorzugten Ausführungsform ist die Steuereinrichtung dazu eingerichtet, die Schalteinrichtungen so anzusteuern, dass der Unterschied zwischen den Einschaltzeiten minimiert ist.

Die Steuereinrichtung kann auch dazu eingerichtet sein, eine Totzeit, während derer weder die erste noch die zweite Schalteinrichtung angesteuert ist, zu minimieren. Vor allem bei einer Anwendung, in der eine induktive Last am Ausgang angeschlossen ist, etwa ein Elektromotor, kann in der Zeit zwischen dem Ausschalten der einen Schalteinrichtung und dem Einschalten der anderen Schalteinrichtung eine hohe Verlustleistung entstehen, wenn der induktive Anteil der Last einen kontinuierlichen Stromfluss erzwingt, der in einer Diodenfunktion einer der Schalteinrichtungen abgeleitet wird. Werden als Ansteuereinrichtungen Feldeffekttransistoren, insbesondere MOSFETs verwendet, so kann ein Strom entgegen der Durchlassrichtung auch dann fließen, wenn der Transistor sperrt. Werden die Ansteuerungen der Schalteinrichtungen dynamisch angepasst, um die Totzeit zu minimieren, so kann eine Asymmetrie zwischen den Einschaltzeiten entstehen oder durch die Anpassung vergrößert werden. Durch die Berücksichtigung des Unterschieds der Einschaltzeiten kann die Minimierung der Totzeiten durchgeführt werden, ohne die beschriebene Verschiebung des Stroms in der Last zu riskieren.

### Kurze Beschreibung der Figuren

Die Erfindung wird nun mit Bezug auf die beigefügten Figuren genauer beschrieben, in denen:
- Fig. 1: ein Schaltbild einer Steuerung für einen elektrischen Verbraucher;
- Fig. 2: eine Vergleichseinrichtung für die Steuerung von Fig. 1 in einer ersten Ausführungsform;
- Fig. 3: eine Vergleichseinrichtung für die Steuerung von Fig. 1 in einer zweiten Ausführungsform, und
- Fig. 4: Abläufe an der Steuerung von Fig. 1 darstellt.

### Genaue Beschreibung von Ausführungsbeispielen

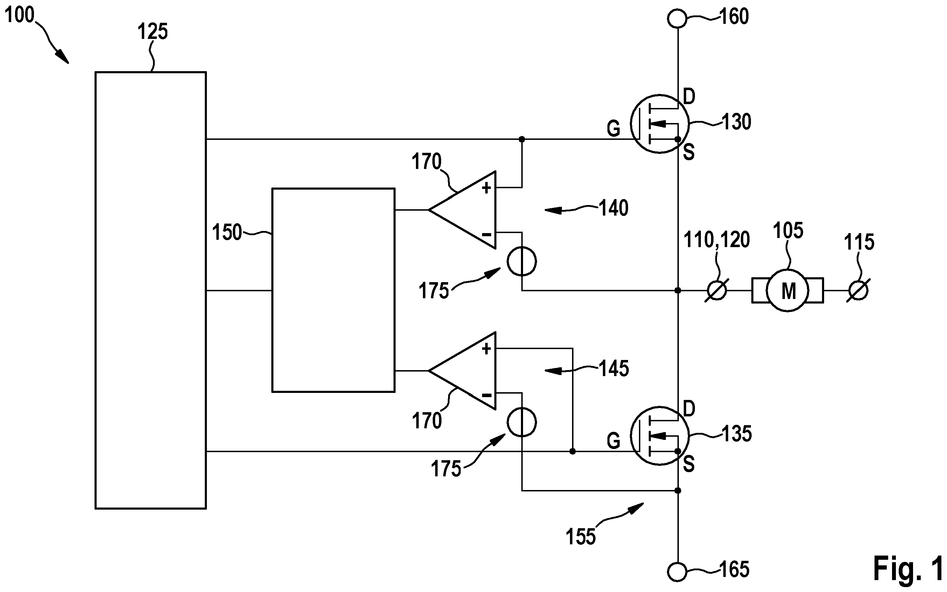

Fig. 1 zeigt ein Schaltbild einer Steuerung 100 für einen elektrischen Verbraucher 105. Der elektrische Verbraucher 105 umfasst einen ersten Anschluss 110 und einen zweiten Anschluss 115, zwischen denen ein Strom fließen kann. Die Steuerung 100 umfasst eine Steuereinrichtung 125, eine erste Schalteinrichtung 130, eine zweite Schalteinrichtung 135, eine erste Abtasteinrichtung 140, eine zweite Abtasteinrichtung 145 und eine Vergleichseinrichtung 150.

Die Schalteinrichtungen 130 und 135 bilden zusammen eine Halbbrücke 155. Die erste Schalteinrichtung 130 ist dazu eingerichtet, einen Stromfluss von einem ersten Potential 160 zum Ausgang 120, und die zweite Schalteinrichtung 135 einen Stromfluss vom Ausgang 120 zu einem zweiten Potential 165 zu steuern. In der dargestellten Ausführungsform ist der erste Anschluss 110 des Verbrauchers 105 mit dem Ausgang 120 verbunden. Der zweite Anschluss 115 des Verbrauchers 105 kann mit einem vorbestimmten Potential verbunden sein, das vorzugsweise zwischen den Potentialen 160 und 165 liegt, oder beispielsweise mit einer weiteren Halbbrücke 155 verbunden sein, die korrespondierend zur Halbbrücke 155 aufgebaut ist und insbesondere antiparallel angesteuert wird, um den Verbraucher 105 in der einen oder der anderen Richtung von Strom durchfließen zu lassen.

Die Schalteinrichtungen 130 und 135 sind in der dargestellten Ausführungsform als MOSFETs ausgeführt, wobei auch andere steuerbare Transistoren oder Schalter verwendet werden können. Insbesondere sind die Schalteinrichtungen 130 und 135 beide als N-Kanalschalter ausgeführt, wobei die erste Schalteinrichtung 130 in Drain-Schaltung und die zweite Schaltung 135 in Source-Schaltung aufgebaut ist. Diese Konstellation kann aus Kostengründen vorteilhaft sein, jedoch können auch bei ansonsten identischen Schalteinrichtungen 130 und 135 unterschiedliche Schaltverhalten, insbesondere unterschiedliche Latenzzeiten der Schalteinrichtungen 130 und 135 bedingt sein. Die Steuereinrichtung 125 ist zur Steuerung mit den Schalteinrichtungen 130 und 135 verbunden.

Die Abtasteinrichtungen 140 und 145 umfassen jeweils einen Komparator 170 und eine Spannungsquelle 175. Die erste Abtasteinrichtung 140 gibt ein positives erstes Signal ab, wenn die Spannung zwischen dem Gate-Anschluss und dem Source-Anschluss der ersten Schalteinrichtung 130 unter die Spannung der zugeordneten Spannungsquelle 175 absinkt. Die zweite Abtasteinrichtung 145 gibt ein positives zweites Signal ab, wenn die Spannung zwischen dem Drain-Anschluss und dem Gate-Anschluss der zweiten Schalteinrichtung 135 unter die Spannung der zugeordneten Spannungsquelle 175 absinkt. In der dargestellten Ausführungsform sind beide Signale positiv, wenn sich die jeweils zugeordnete Schalteinrichtung 130, 135 im geschlossenen Schaltzustand befindet. Die Polaritäten können jedoch auch geändert werden, so dass sich negative Signale ergeben, wenn sich die Schalteinrichtungen 130, 135 jeweils im leitenden Zustand befinden.

Die Signale der Abtasteinrichtungen 140 und 145 werden der Vergleichseinrichtung 150 bereitgestellt, die dazu eingerichtet ist, auf der Basis eines Unterschiedes der Längen des ersten und des zweiten Signals unterschiedlich lange Einschaltzeiten der Schalteinrichtungen 130 und 135 zu bestimmen. Das Ergebnis der Bestimmung wird vorzugsweise der Steuereinrichtung 125 bereitgestellt. Die Steuereinrichtung 125 kann dazu eingerichtet sein, die für die Schalteinrichtungen 130 und 135 bereitgestellten Steuersignale anzupassen, um den bestimmten Unterschied möglichst zu minimieren.

Ferner kann die Steuereinrichtung 125 dazu eingerichtet sein, eine Totzeit, während derer sich weder die erste Schalteinrichtung 130 noch die zweite Schalteinrichtung 135 im geschlossenen Schaltzustand befindet, zu minimieren. Diese Minimierung kann insbesondere bei einer periodischen Ansteuerung der Schalteinrichtungen 130 und 135, beispielsweise im Rahmen einer Pulsweitenmodulation (PWM) Anwendung finden.

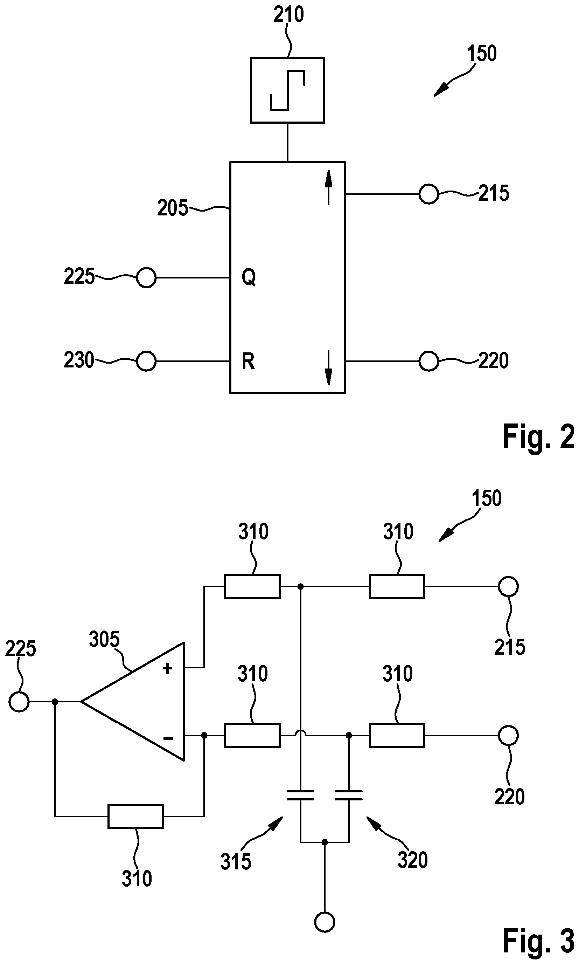

Fig. 2 zeigt die Vergleichseinrichtung 150 für die Steuerung 100 von Fig. 1 in einer ersten, digitalen Ausführungsform. Die dargestellte Vergleichseinrichtung 150 umfasst einen digitalen Zähler 205, der dazu eingerichtet ist, ein vorzugsweise gleichmäßiges Taktsignal eines Taktgenerators 210 aufwärts oder abwärts zu zählen. Liegt an einem ersten Steuereingang 215 ein entsprechendes Signal an, so wird das Taktsignal des Taktgenerators 210 aufsteigend gezählt, liegt ein Signal an einem zweiten Steuereingang 220, so wird das Taktsignal absteigend gezählt. Die Zählrichtungen können auch vertauscht sein. Die Steuereingänge 215 und 220 sind mit Ausgängen der Abtasteinrichtungen 140 bzw. 145 verbunden, um deren bereitgestellte erste und zweite Signale aufzunehmen. Da die bereitgestellten Signale zu Einschaltzeiten der Schalteinrichtungen 130 bzw. 135 korrespondieren und sich nicht beide Schalteinrichtungen 130, 135 im geschlossenen Schaltzustand befinden dürfen, um einen Kurzschluss zwischen dem ersten Potential 160 und dem zweiten Potential 165 zu verhindern, sind auch die beiden Signale an den Steuereingängen 215 und 220 nicht gleichzeitig aktiv. Ein Konflikt, gleichzeitig aufwärts und abwärts zählen zu müssen, entsteht daher für den Zähler 205 nicht.

An einem Ausgang 225 stellt der Zähler 205 seinen Zählerstand bereit. Der Ausgang 225 ist bevorzugterweise mit der Steuereinrichtung 125 der Steuerung 100 aus Fig. 1 verbunden. In einer einfachen Ausführungsform signalisiert der Ausgang 225 lediglich, ob der Zählerstand des Zählers 205 einen vorbestimmten Wert aufweist oder nicht. In einer Verfeinerung kann auch signalisiert werden, ob der Zählerstand in einem vorbestimmten Bereich um den vorbestimmten Wert liegt. Der vorbestimmte Zählerstand kann beispielsweise mittels eines Signals an einem Rücksetz-Eingang 230 gesetzt werden und insbesondere Null betragen. Der Rücksetz-Eingang 230 kann insbesondere durch die Steuereinrichtung 125 gesteuert werden oder es kann aus einem der Steuersignale der Schalteinrichtungen 130, 135 ein Rücksetz-Signal abgeleitet werden, um jeweils nur die Schaltzeiten aus einer Periode zu bestimmen. Wird nach dem Setzen des Zählerstands beispielsweise zuerst die erste Schalteinrichtung 130 und danach die zweite Schalteinrichtung 135 jeweils für eine vorbestimmte Zeitdauer angesteuert, so zählt der digitale Zähler 205 zuerst eine Anzahl Schritte nach oben und dann eine Anzahl Schritte nach unten. Wurden beide Schalteinrichtungen 130, 135 gleich lang geschlossen, so entspricht der aktuelle Zählerstand des Zählers 205 wieder dem eingangs gesetzten Zählerstand. Andernfalls waren die Einschaltdauern der Schalteinrichtungen 130, 135 ungleich lang.

In einer bevorzugten Ausführungsform wird das Ergebnis dieser Bestimmung als absoluter Zählerstand am Ausgang 225 bereitgestellt, so dass die Abweichung vom vorbestimmten Zählerstand seitens der Steuereinrichtung 125 bestimmt werden kann. Die Schalteinrichtungen 130, 135 werden üblicherweise abwechselnd und periodisch angesteuert, wobei ein Rücksetzen des Zählers 205 auf den vorbestimmten Zählerstand nach einer oder nach mehreren Perioden erfolgen kann.

Fig. 3 zeigt eine Vergleichseinrichtung 150 für die Steuerung 100 von Fig. 1 in einer zweiten, analogen Ausführungsform, die alternativ zu der in Fig. 2 gezeigten Ausführungsform in der Steuerung 100 verwendet werden kann. Die Steuereingänge 215 und 220 sowie der Ausgang 225 sind von der in Fig. 2 gezeigten Ausführungsform übernommen, der Rücksetz-Eingang 230 entfällt. Die gezeigte Vergleichseinrichtung 150 ist als integrierender Komparator um einen Verstärker 305 aufgebaut. Gesteuert durch eine Anzahl Widerstände 310 wird in einem ersten Kondensator 315 eine Spannung in Abhängigkeit des ersten Signals am ersten Steuereingang 215 über die Zeit integriert. In gleicher Weise wird in einem zweiten Kondensator 320 das zweite Signal am zweiten Steuereingang 220 über die Zeit integriert. Dabei erfolgt die Integration des ersten Signals positiv und die des zweiten Signals negativ, wobei auch eine umgekehrte Zuordnung von Signalen zu Vorzeichen verwendet werden kann. Am Ausgang 225 der Vergleichseinrichtung 150 wird eine Spannung bereitgestellt, deren Abweichung von einem vorbestimmten Wert den Unterschied der Einschaltzeiten der Schalteinrichtungen 130 und 135 darstellt. Der vorbestimmte Wert entspricht dabei dem vorbestimmten Zählerstand des Zählers 205 der in Fig. 2 gezeigten Ausführungsform.

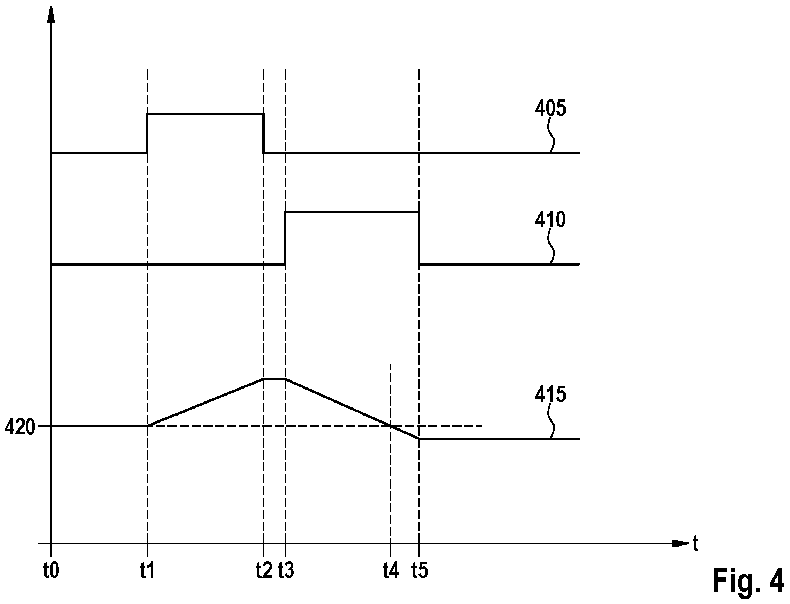

Fig. 4 zeigt Abläufe an der Steuerung 100 von Fig. 1. In horizontaler Richtung ist eine Zeit angetragen, in vertikaler Richtung ein Wert bzw. ein Signal. Ein erstes Signal 405 ist durch die erste Abtasteinrichtung 140 in Fig. 1 bereitgestellt und liegt jeweils am ersten Steuereingang 215 der Vergleichseinrichtungen 150 in einer der unterschiedlichen Ausführungsformen der Fign. 2 und 3 an. Ein zweites Signal 410 ist in korrespondierender Weise von der zweiten Abtasteinrichtung 145 bereitgestellt und liegt jeweils am zweiten Steuereingang 220 der Vergleichseinrichtung 150 an. Ein Vergleichssignal 415 repräsentiert bei der digitalen Variante der Vergleichseinrichtung 150 von Fig. 2 den Zählerstand des digitalen Zählers 205 und an der analogen Variante von Fig. 3 zur Spannung am Ausgang 225 des Verstärkers 305.

Zu einem Zeitpunkt t0 sind beide Signale 405 und 410 inaktiv, die korrespondierenden Schalteinrichtungen 130 bzw. 135 sind also nicht geschlossen und das Vergleichssignal 415 nimmt einen vorbestimmten Stand 420 ein. Dieser Stand kann insbesondere als Nullpunkt definiert sein.

Zu einem Zeitpunkt t1 wird die erste Schalteinrichtung 130 angesteuert und das Vergleichssignal 415 steigt über die Zeit linear an. Zu einem Zeitpunkt t2 wird das erste Signal 405 wieder deaktiviert. Bis zu einem Zeitpunkt t3 vergeht eine Totzeit, während derer keines der Signale 405 oder 410 aktiv ist. Während dieser Zeit bleibt das Vergleichssignal 415 auf seinem zum Zeitpunkt t2 eingenommenen Wert.

Nach einem Aktivieren des zweiten Signals 410 zum Zeitpunkt t3 sinkt das Vergleichssignal 415 mit der gleichen Geschwindigkeit ab, mit der es zwischen den Zeitpunkten t1 und t2 zuvor anstieg. Zu einem Zeitpunkt t4 erreicht das Vergleichssignal 415 in dem hier dargestellten Beispiel den Stand 420. Das zweite Signal 410 bleibt jedoch noch länger, und zwar bis zum Zeitpunkt t5 aktiv und wird erst dann deaktiviert, worauf hin das Vergleichssignal 415 wieder auf seinem aktuellen Wert gehalten wird. Der Wert des Vergleichssignals 415 nach dem Zeitpunkt t5 ist kleiner als der Stand 420, was andeutet, dass das zweite Signal 410 länger als das erste Signal 405 war. Im umgekehrten Fall, wenn das erste Signal 405 länger als das zweite Signal 410 ist, liegt der Wert des Vergleichssignals 415 nach dem Zeitpunkt t5, wenn beide Signale 405, 410 wieder deaktiviert sind, oberhalb des Stands 420. In beiden Fällen gibt der Betrag des Abstands zwischen dem Vergleichssignal 415 und dem Stand 420 jeweils ein Maß für die Größe der Abweichung der zeitlichen Dauern der Signale 405 und 410.

## Patentansprüche

1. Steuerung (100) für einen elektrischen Verbraucher (105), wobei die Steuerung (100) folgende Elemente umfasst:
- eine erste Schalteinrichtung (130) zur Verbindung eines Ausgangs (120) für den Verbraucher (105) mit einem ersten Potential (160);
- eine zweite Schalteinrichtung (135) zur Verbindung des Ausgangs (120) mit einem zweiten Potential (165);
- eine Steuereinrichtung (125) zur Ansteuerung der Schalteinrichtungen (130, 135);
- eine erste Abtasteinrichtung (140) zur Bereitstellung eines ersten Signals (410) in Abhängigkeit eines Schaltzustands der ersten Schalteinrichtung (130);
- eine zweite Abtasteinrichtung (145) zur Bereitstellung eines zweiten Signals (410) in Abhängigkeit eines Schaltzustands der zweiten Schalteinrichtung (135);
- eine Vergleichseinrichtung (150) zur Bestimmung eines Unterschieds der Einschaltzeiten der Schalteinrichtungen (130, 135) auf der Basis der bestimmten Signale (410, 415);
**dadurch gekennzeichnet, dass**
- die Vergleichseinrichtung (150) dazu eingerichtet ist, Unterschiede der Einschaltzeiten über mehrere periodische Ansteuerungen der Schalteinrichtungen (130, 135) aufzusummieren und
- die Schalteinrichtungen (130, 135) so anzusteuern, dass die Unterschiede zwischen den Einschaltzeiten minimiert sind.

2. Steuerung (100) nach Anspruch 1, wobei eine der Schalteinrichtungen (130, 135) einen Feldeffekttransistor umfasst und die zugeordnete Abtasteinrichtung (140, 145) dazu eingerichtet ist, einen geschlossenen Schaltzustand zu bestimmen, wenn eine Spannung zwischen einem Gate- und einem Source-Anschluss des Feldeffekttransistors unter einem vorbestimmten Schwellenwert liegt.

3. Steuerung (100) nach einem der Ansprüche 1 oder 2, wobei die Vergleichseinrichtung (150) einen integrierenden Komparator (305) umfasst, der dazu eingerichtet ist, auf der Basis der bestimmten Signale (405, 410) eine Spannung bereitzustellen, deren Abweichung von einem vorbestimmten Potential (420) ein Maß für den Unterschied der Einschaltzeiten darstellt.

4. Steuerung (100) nach einem der Ansprüche 1 oder 2, wobei die Vergleichseinrichtung (150) einen digitalen Zähler (205) umfasst, der dazu eingerichtet ist, ein gleichbleibendes Taktsignal während des ersten Signals (405) aufwärts und während des zweiten Signals (410) abwärts zu zählen, wobei die Abweichung des Zählerstands von einem vorbestimmten Stand (420) ein Maß für den Unterschied der Einschaltzeiten darstellt.

5. Steuerung (100) nach einem der vorangehenden Ansprüche, wobei die Steuereinrichtung (125) dazu eingerichtet ist, die Schalteinrichtungen (130, 135) im Rahmen einer Pulsweitenmodulation periodisch anzusteuern.

6. Steuerung (100) nach einem der vorangehenden Ansprüche, wobei die Schalteinrichtungen (130, 135) von einer Halbbrücke (155) umfasst sind.

7. Steuerung (100) nach einem der vorangehenden Ansprüche, wobei die Schalteinrichtungen (130, 135) von einem Brückenzweig (155) einer H-Brücke umfasst sind

8. Steuerung (100) nach einem der vorangehenden Ansprüche, wobei die Steuereinrichtung (125) dazu eingerichtet ist, eine Totzeit, während derer weder die erste (130) noch die zweite Schalteinrichtung (135) angesteuert ist, zu minimieren.

## Claims

1. Controller (100) for an electrical load (105), wherein the controller (100) comprises the following elements:
- a first switching device (130) for connecting an output (120) for the load (105) to a first potential (160);
- a second switching device (135) for connecting the output (120) to a second potential (165);
- a control device (125) for controlling the switching devices (130, 135);
- a first scanning device (140) for providing a first signal (410) on the basis of a switching state of the first switching device (130);
- a second scanning device (145) for providing a second signal (410) on the basis of a switching state of the second switching device (135);
- a comparison device (150) for determining a difference between the switch-on times of the switching devices (130, 135) on the basis of the determined signals (410, 415);
**characterized in that**
- the comparison device (150) is configured to add up differences between the switch-on times over a plurality of periodic operations of controlling the switching devices (130, 135) and
- to control the switching devices (130, 135) in such a manner that the differences between the switch-on times are minimized.

2. Controller (100) according to Claim 1, wherein one of the switching devices (130, 135) comprises a field effect transistor and the associated scanning device (140, 145) is configured to determine a closed switching state if a voltage between a gate connection and a source connection of the field effect transistor is below a predetermined threshold value.

3. Controller (100) according to either of Claims 1 and 2, wherein the comparison device (150) comprises an integrating comparator (305) which is configured to provide a voltage on the basis of the determined signals (405, 410), the deviation of which voltage from a predetermined potential (420) is a measure of the difference between the switch-on times.

4. Controller (100) according to either of Claims 1 and 2, wherein the comparison device (150) comprises a digital counter (205) which is configured to increment a constant clock signal during the first signal (405) and to decrement it during the second signal (410), wherein the deviation of the counter reading from a predetermined reading (420) is a measure of the difference between the switch-on times.

5. Controller (100) according to one of the preceding claims, wherein the control device (125) is configured to periodically control the switching devices (130, 135) within the scope of pulse width modulation.

6. Controller (100) according to one of the preceding claims, wherein the switching devices (130, 135) are included in a half-bridge (155).

7. Controller (100) according to one of the preceding claims, wherein the switching devices (130, 135) are included in a bridge arm (155) of an H-bridge.

8. Controller (100) according to one of the preceding claims, wherein the control device (125) is configured to minimize a dead time during which neither the first switching device (130) nor the second switching device (135) is controlled.

## Revendications

1. Commande (100) pour un récepteur (105) électrique, la commande (100) comprenant les éléments suivants :
- un premier dispositif de commutation (130) destiné à relier une sortie (120) pour le récepteur (105) à un premier potentiel (160) ;
- un deuxième dispositif de commutation (135) destiné à relier la sortie (120) à un deuxième potentiel (165) ;
- un dispositif de commande (125) destiné à piloter les dispositifs de commutation (130, 135) ;
- un premier dispositif de balayage (140) destiné à fournir un premier signal (410) en fonction d'un état de commutation du premier dispositif de commutation (130) ;
- un deuxième dispositif de balayage (145) destiné à fournir un deuxième signal (410) en fonction d'un état de commutation du deuxième dispositif de commutation (135) ;
- un dispositif de comparaison (150) destiné à déterminer une différence entre les temps de mise en circuit des dispositifs de commutation (130, 135) sur la base des signaux (410, 415) déterminés ;
**caractérisée en ce que**
- le dispositif de comparaison (150) est conçu pour additionner les différences des temps de mise en circuit sur plusieurs pilotages périodiques des dispositifs de commutation (130, 135) et
- piloter les dispositifs de commutation (130, 135) de telle sorte que les différences entre les temps de mise en circuit sont réduites au minimum.

2. Commande (100) selon la revendication 1, l'un des dispositifs de commutation (130, 135) comprenant un transistor à effet de champ et le dispositif de balayage (140, 145) associé étant conçu pour déterminer un état de commutation fermé lorsqu'une tension entre une borne de gâchette et une borne de source du transistor à effet de champ est inférieure à une valeur de seuil prédéterminée.

3. Commande (100) selon la revendication 1 ou 2, le dispositif de comparaison (150) comprenant un comparateur (305) intégré qui est conçu pour, sur la base des signaux (405, 410) déterminés, fournir une tension dont l'écart d'un potentiel (420) prédéterminé représente une mesure pour la différence des temps de mise en circuit.

4. Commande (100) selon l'une des revendications 1 ou 2, le dispositif de comparaison (150) comprenant un compteur numérique (205) qui est conçu pour compter un signal d'horloge constant pendant le premier signal (405) et le décompter pendant le deuxième signal (410), l'écart entre l'état de comptage et un état prédéterminé (420) représentant une mesure pour la différence des temps de mise en circuit.

5. Commande (100) selon l'une des revendications précédentes, le dispositif de commande (125) étant conçu pour piloter les dispositifs de commutation (130, 135) périodiquement dans le cadre d'une modulation d'impulsions en largeur.

6. Commande (100) selon l'une des revendications précédentes, les dispositifs de commutation (130, 135) étant compris par un demi-pont (155).

7. Commande (100) selon l'une des revendications précédentes, les dispositifs de commutation (130, 135) étant compris par une branche de pont (155) d'un pont en H.

8. Commande (100) selon l'une des revendications précédentes, le dispositif de commande (125) étant conçu pour réduire au minimum un temps mort pendant lequel ni le premier (130) ni le deuxième dispositif de commutation (135) ne sont pilotés.
